# EUROPEAN PATENT SPECIFICATION

(11) **EP 2 829 629 B1**
(45) Date of publication and mention of the grant of the patent: **03.05.2017**
(21) Application number: 13764235.1
(22) Date of filing: 20.02.2013
(51) Int. Cl.: C23C 14/00, C23C 16/44, C23G 5/032, C23F 1/12

(54) **METHOD FOR DRY-CLEANING METAL FILM IN FILM-FORMATION APPARATUS**
VERFAHREN ZUR TROCKENREINIGUNG EINES METALLFILMS IN EINER FILMBILDUNGSVORRICHTUNG
PROCÉDÉ DE NETTOYAGE À SEC D'UN FILM MÉTALLIQUE DANS UN APPAREIL DE FORMATION DE FILM

(30) Priority: 22.03.2012 JP 2012065523
(43) Date of publication of application: 28.01.2015
(73) Proprietor: CENTRAL GLASS COMPANY, LIMITED, Ube-shi, Yamaguchi 755-0001 (JP)
(72) Inventor: UMEZAKI, Tomonori, Ube-shi Yamaguchi 755-0001 (JP); TAKEDA, Yuta, Ube-shi Yamaguchi 755-0001 (JP); MORI, Isamu, Tokyo 101-0054 (JP)
(74) Representative: Manitz Finsterwald Patentanwälte PartmbB
(86) International application number: PCT/JP2013/054177
(87) International publication number: WO 2013/140926

(56) References cited:
- WO-A1-2004/006316
- WO-A1-2004/073056
- WO-A1-2012/117758
- JP-A- H11 140 652
- JP-A- 2001 284 330
- JP-A- 2005 244 256
- JP-A- 2007 270 231
- JP-A- 2007 515 780
- JP-A- 2009 043 973
- US-B1- 6 534 413
- BECK S E ET AL: "VAPOR PHASE CLEANING WITH BETA-DIKETONES", PROCEEDINGS INSTITUTE OF ENVIRONMENTAL SCIENCES, XX, XX, 1 January 1998 (1998-01-01), pages 80-86, XP008009817,

## Description

### TECHNICAL FIELD

The present invention relates to a dry-cleaning method in a film-formation apparatus.

### BACKGROUND OF THE INVENTION

In the production process of semiconductor elements, a metal film is formed as a metal gate material, an electrode material or a magnetic material on the substrate surface by a film-formation apparatus. Upon this, besides on the substrate surface, there occurs an adhesion of unnecessary metal films, etc. on the surfaces in the inside of the film-formation apparatus, such as a stage for holding and heating the substrate in a film-formation chamber of the apparatus, an electrode for generating plasma, or other jigs, and furthermore an inner wall of the chamber and as one connecting with this an inner wall of piping, etc. Therefore, it is necessary to remove this. There is known a dry-cleaning method using β-diketone, as a method for removing unnecessary metal films, etc. under a condition that the inside of the chamber is heated after the substrate has been taken out of the chamber. For example, there is known a dry-cleaning method of reacting and removing a metal oxide film as a metal coordination compound by bringing β-diketone, such as hexafluoroacetylacetone (in the following, abbreviated as HFAcAc), into contact with the metal oxide film (e.g., Patent Publication 1). However, when this method is conducted against a metal film, it is not possible to turn the metal into an oxidized condition, resulting in no progress in etching reaction. Thus, there is known a. dry-cleaning method that makes it possible to react and remove a metal film as a metal coordination compound by using a combination of oxygen and β-diketone, such as HFAcAc (e.g., Patent Publications 2 and 3).

### PRIOR ART PUBLICATIONS

### NON-PATENT PUBLICATIONS

Patent Publication 1: Japanese Patent Application Publication 2001-176807.
Patent Publication 2: Japanese Patent 4049423.
Patent Publication 3: Japanese Patent Application Publication Heisei 6-101076.
S.E. Beck et. al. discuss in "Vapor Phase Cleaning with β-Diketones" (Proceedings - Institute of Environmental Sciences and Technology, 1998, pages 80 - 86 ) methods for wafer cleaning to remove metal contaminants and CVD chamber cleaning to prevent recontamination of the wafer during copper CVD.
JP 2009-043973 discloses a manufacturing method of a semiconductor device capable of preventing film peeling from occurring easily.
US 6,534,413 B1 discloses a method for removing sacrificial materials and metal contamination from silicon surfaces during the manufacture of an integrated micromechanical device.

### SUMMARY OF THE INVENTION

In general, when conducting a dry-cleaning of a metal film adhered to sites other than the substrate surface, after depositing the metal film on the surface of the substrate, there occur temperature differences among adhesion sites of the metal film, such as the inner wall of the chamber heated to high temperature, thereby causing a wide temperature distribution. Hitherto, in a dry-cleaning method of a metal film using β-diketone, in a method for removing a metal film as the removal target by etching using β-diketone and oxygen, in case that the temperature distribution of the metal film among adhesion sites ranges, for example, from 250 °C to 370 °C, etching does not progress at all at a low temperature site of around 250 °C, thereby causing a phenomenon that the temperature range in which the etching removal is possible gets narrower. Such phenomenon becomes conspicuous, particularly when the metal is nickel.

Therefore, there is a demand for a dry-cleaning method capable of conducting an efficient cleaning, even in case that the temperature difference among adhesion sites of the metal film is large when conducting a cleaning of a chamber inner wall, etc. under a heated condition at high temperature without opening the chamber.

It is an object of the present invention to solve the above-mentioned problem and to provide a dry-cleaning method capable of progressing etching, even if the temperature difference among sites of the adhered metal film occurs, when removing the metal film adhered in the inside of the film-formation apparatus.

As a result of a repeated eager study, the present inventors have found that, in a dry-cleaning method for removing a metal film adhered in the inside of a film-formation apparatus (for example, CVD apparatus, sputtering apparatus, vacuum deposition apparatus, etc.) using β-diketone, it becomes possible to progress etching of the adhered metal film in a wide temperature range in the film-formation apparatus by using a gas containing β-diketone and NOx (representing at least one of NO and N₂O) as a cleaning gas.

That is, the present invention provides a dry-cleaning method for removing a metal film adhered in the inside of a film-formation apparatus by using β-diketone, the dry-cleaning method (first method) being characterized by that a gas containing β-diketone and NOx (representing at least one of NO and N₂O) is used as a cleaning gas and that the metal film within a temperature range of 200 °C to 400 °C is reacted with the cleaning gas, thereby removing the metal film, wherein the gas has a NOx/β-diketone ratio by volume of from 0.02 to 0.60.

The first method may be a dry-cleaning method (second method), which is characterized by that the β-diketone is hexafluoroacetylacetone or trifluoroacetylacetone.

The first or second method may be a dry-cleaning method (third method), which is characterized by that the cleaning gas contains at least one gas selected from the group consisting of He, Ar, and N₂.

The first method may be a dry-cleaning method (fourth method), which is characterized by that the metal film is constituted of at least one element of from group 6 to group 11 of the periodic table.

### ADVANTAGEOUS EFFECT OF THE INVENTION

By using the dry-cleaning method of the present invention, it becomes possible to efficiently conduct a cleaning of a metal film adhered in the inside of a film-formation apparatus, due to a wide temperature range in which the etching removal is possible.

### BRIEF DESCRIPTION OF THE DRAWINGS

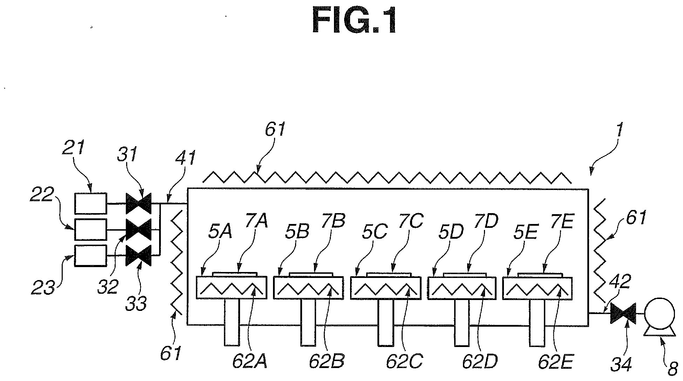

Fig. 1 shows a schematic system diagram of an apparatus used in the test.

### DETAILED DESCRIPTION

The removal target by the dry-cleaning method of the present invention is a metal film. This metal film is constituted of at least one of elements of group 6 to group 11 of the periodic table. Specifically, it is possible to cite elements, such as Cr, Mo, W, Mn, Fe, Ru, Co, Ir, Ni, Pd, Pt, Cu, Ag, and Au. As the metal film constituted of the element, it is possible to cite, for example, a film made of any one of the elements. It may be a metal film constituted of a plurality of the elements. For example, it is possible to cite NiFe, CoFe, CoFeNi, NiFeCr, NiFeMo, CuNiFe, etc. On a metal film containing any of Cr, Mn, Fe, Ni, Co, and Pt as constituent elements, the advantageous effect of the present invention becomes conspicuous.

In the dry-cleaning method of the present invention, a cleaning gas is introduced into a film-formation apparatus and brought into contact with a metal film adhered in the film-formation apparatus to generate a reaction to form a metal coordination compound, thereby removing the metal film by etching. Upon this, the cleaning gas must contain β-diketone and NOx (representing at least one of NO and N₂O). The reason why the temperature range in which the metal film can be removed by etching becomes wider by using NOx as compared with O₂ used hitherto is not certain. We have not found a similar advantageous effect in NO₂, which belongs to the same nitrogen oxides and has an oxidative action. Therefore, it is considered to be an action special to NO and N₂O, in which reactivity of complexation of a metal oxide film generated by an oxidative action improves by not only the oxidative action of NO and/or N₂O but also an interaction between NO or N₂O and β-diketone.

As β-diketone, it is possible to cite, for example, hexafluoroacetylacetone, trifluoroacetylacetone, acetylacetone, etc. It is possible to use not only one type, but also at least two types. In particular, in terms of etching capability at high rate, hexafluoroacetylacetone and trifluoroacetylacetone are preferable. Etching rate of the metal film increases with the increase of concentration of β-diketone contained in the cleaning gas. In case that vapor pressure of β-diketone is low to cause a risk of possibility of liquefaction in the film-formation apparatus, it is preferable to suitably adjust the concentration by a diluting gas.

The volume fraction of NOx contained in the cleaning gas relative to volume fraction of β-diketone contained in the cleaning gas, that is, the NOx/β-diketone ratio, is from 0.02 to 0.60. If NOx/β-diketone ratio is less than 0.02 or exceeds 0.60, there is a risk of lowering of etching rate of the metal film.

It is optional that NO and N₂O are mixed together in the cleaning gas, and its ratio is not particularly limited.

It is optional that at least one gas selected from inert gases, such as N₂, He and Ar, is mixed in the cleaning gas, together with the above-mentioned β-diketone and NOx. Its concentration is not particularly limited. For example, it is usable by setting the concentration of inert gas in a range of 0 to 90 volume %.

As to temperature during the cleaning, etching is possible as long as temperature of the metal film as the removal target is in a temperature range of 200 °C to 400 °C. It is preferably from 250 °C to 370 °C. In particular, it is desirable to be from 260 °C to 350 °C in order to obtain a higher etching rate.

Pressure in the inside of the chamber during the cleaning is not particularly limited. In general, the pressure range in the film formation is from 0.1 kPa to 101.3 kPa. Etching is also possible in this pressure range.

By conducting a dry-cleaning under the above-mentioned conditions, it becomes possible to efficiently remove the metal film adhered in the film-formation chamber or in the piping. This is the same, even if the inside of the film-formation chamber immediately after taking the substrate out of the chamber after forming a film on the substrate is in a heated condition, or even if the chamber has been once cooled and then reheated.

In particular, in the case of a CVD apparatus using a chemical vapor deposition method for forming a metal film, the temperature of the film-forming substrate of the film formation process is as high as 300 °C or higher, as compared with that according to other film formation apparatuses. Therefore, there is a large temperature difference between that and a low-temperature section, which is lower than 300 °C, in the film formation chamber. Thus, in view of the effect on the film formation process, it is preferable to conduct a cleaning for removing a metal film adhered in the film formation chamber, under a condition of a wide temperature distribution in the film formation apparatus. Therefore, it is particularly effective for a cleaning in a CVD apparatus.

### EXAMPLES

In the present test, in order to examine the etching behavior of a metal film depending on the temperature distribution in the chamber, a test was conducted by using a chamber equipped in the inside with five heater stages each carrying a sample of a metal film adhered.

Fig. 1 is a schematic system diagram of an apparatus used in the present test. In the chamber 1, heater stages 5A to 5E are provided. Outside of the chamber 1 and in the insides of the heater stages 5A, 5B, 5C, 5D and 5E, heaters 61, 62A, 62B, 62C, 62D and 62E are provided. It is possible to separately set each stage at a predetermined temperature. This heater stage 5A, 5B, 5C, 5D or 5E carries thereon a sample 7A, 7B, 7C, 7D or 7E. The sample 7A, 7B, 7C, 7D or 7E is a metal foil (shape: 2 cm x 2 cm, thickness: 0.1 mm). The metal foil is one assumed to be a metal film adhered in the film formation apparatus.

To the chamber 1, there are connected a gas pipe 41 for introducing gas and a gas pipe 42 for discharging gas. β-diketone supply system 21, NOx gas supply system 22, and diluting gas introducing system 23 are connected to the gas pipe 41 through valves 31, 32 and 33. A vacuum pump 8 is connected to the gas pipe 42 through a valve 34. Pressure of the inside of the chamber 1 is controlled by the valve 34, based on the indicated value of a pressure gauge (omitted in the drawings) attached to the chamber 1.

Next, the operation method is explained. The insides of the chamber 1 and the gas pipes 41 and 42 were subjected to a vacuum displacement until less than 10 Pa. Then, the samples, which have been placed on the heater stages and of which weights have been measured, are heated at a predetermined temperature by the heaters 61, 62A, 62B, 62C, 62D and 62E. After confirming that the heaters 61 and 62A to 62E have reached predetermined values, the valves 31, 32 and 33 are opened. While a cleaning gas is introduced into the chamber 1 by supplying β-diketone, NOx and the diluting gas from β-diketone supply system 21, NOx gas supply system 22, and diluting gas supply system 23 at predetermined flow rates, the inside of the chamber 1 is adjusted to a predetermined pressure. After the start of the introduction, after a lapse of a predetermined time (10 minutes), the introduction of the cleaning gas is stopped. The inside of the chamber 1 is subjected to a vacuum displacement. Then, the samples are taken out to measure their weights. The amount of etching is calculated from the weight change of the sample before and after the test. In this case, due to the measurement accuracy of a scale for measuring the weight, the quantitative lower limit of the amount of etching to be calculated is 20 nm.

### [EXAMPLES 1-21]

In the present test, the total flow rate of the cleaning gas to be introduced was 500 sccm. The diluting gas was N₂. The samples 7A, 7B, 7C, 7D, and 7E were respectively heated at 240 °C, 275 °C, 300 °C, 325 °C and 370 °C.

Furthermore, the above test was conducted by adjusting the volume concentration of hexafluoroacetylacetone as β-diketone in the cleaning gas to 50 %, changing volume concentration of NO as NOx in the cleaning gas to a concentration shown in Table 1, adjusting the pressure in the inside of the chamber to 13.3 kPa, and using a Ni foil as the metal foil (Examples 1-6). Examples 4 and 6 are, due to their NOx/β-diketone ratio being outside of the range of 0.02 to 0.60, not according to the invention and therefore comparative examples.

Furthermore, Example 1 was repeated except in that the pressure in the inside of the chamber was adjusted to 40 kPa (Example 7), 6.7 kPa (Example 8), 1.3 kPa (Example 9), and 80 kPa (Example 10).

Furthermore, Example 1 was repeated except in that β-diketone was trifluoroacetylacetone (Example 11).

Furthermore, Example 1 was repeated except in that N₂O was used as NOx (Example 12).

Furthermore, Example 1 was repeated except in that the volume concentration of hexafluoroacetylacetone in the cleaning gas was adjusted to 25 %, and that the volume concentration of NO in the cleaning gas was adjusted to 5 % (Example 13).

Furthermore, Example 1 was repeated except in that the volume concentration of hexafluoroacetylacetone in the cleaning gas was adjusted to 83 %, and that the volume concentration of NO in the cleaning gas was adjusted to 17 % (Example 14).

Furthermore, Example 1 was repeated except in that, as shown in Table 1, the metal foil was changed to Cr, Mn, Fe, Co, Pt, or NiFe alloy (permalloy, an alloy of Fe : Ni = 22 : 78) (Examples 15-20).

Example 1 was repeated except in that the volume concentrations of NO and N₂O in the cleaning gas were respectively adjusted to 5 % and 5 %, 10 % in total (Example 21).

Table 1 shows the gas, the pressure and the temperature condition of the test and the result of calculating the amount of etching. As a result, it was confirmed that all the samples with different temperatures were etched in all of Examples.

It has been confirmed that the result is similar even if changing the diluting gas from N₂ to Ar or He.

**[Table 1]**

| Test No. | | | | Conc. (vol. %) | | NOx/β-diketone vol. ratio | Chamber pressure kPa | Amount of etching (nm) | | | | |
|---|---|---|---|---|---|---|---|---|---|---|---|---|
| | Metal | β-diketone | NOx | β-diketone | NOx | | | Sample A 240°C | Sample B 275°C | Sample C 300°C | Sample D 325°C | Sample E 370°C |
| Ex. 1 | Ni | HFAcAc | NO | 50% | 10% | 0.20 | 13.3kPa | 700nm | 1800nm | 1600nm | 1400nm | 1200nm |
| Ex. 2 | Ni | HFAcAc | NO | 50% | 5% | 0.10 | 13.3 kPa | 1000nm | 2000nm | 3200nm | 4000nm | 3900nm |
| Ex. 3 | Ni | HFAcAc | NO | 50% | 2% | 0.04 | 13.3 kPa | 700nm | 1500nm | 1800nm | 2000nm | 1900nm |
| Ex. 4 | Ni | HFAcAc | NO | 50% | 0.5% | 0.01 | 13.3 kPa | 100nm | 150nm | 150nm | 100nm | 90nm |
| Ex. 5 | Ni | HFAcAc | NO | 50% | 25% | 0.50 | 13.3 kPa | 900nm | 1100nm | 1300nm | 1500nm | 1300nm |
| Ex. 6 | Ni | HFAcAc | NO | 50% | 35% | 0.70 | 13.3 kPa | 80nm | 200nm | 300nm | 300nm | 280nm |
| Ex. 7 | Ni | HFAcAc | NO | 50% | 10% | 0.20 | 40 kPa | 1500nm | 2100nm | 3500nm | 3100nm | 2500nm |
| Ex. 8 | Ni | HFAcAc | NO | 50% | 10% | 0.20 | 6.7 kPa | 600nm | 1500nm | 1400nm | 1400nm | 1300nm |
| Ex. 9 | Ni | HFAcAc | NO | 50% | 10% | 0.20 | 1.3 kPa | 200nm | 500nm | 500nm | 400nm | 350nm |
| Ex. 10 | Ni | HFAcAc | NO | 50% | 10% | 0.20 | 80 kPa | 1400nm | 2000nm | 3200nm | 3000nm | 2000nm |
| Ex. 11 | Ni | TFAcAc | NO | 50% | 10% | 0.20 | 13.3 kPa | 500nm | 1300nm | 1100nm | 1000nm | 900nm |
| Ex. 12 | Ni | HFAcAc | N2O | 50% | 10% | 0.20 | 13.3 kPa | 200nm | 400nm | 500nm | 600nm | 500nm |
| Ex. 13 | Ni | HFAcAc | NO | 25% | 5% | 0.20 | 13.3 kPa | 400nm | 800nm | 800nm | 700nm | 600nm |
| Ex. 14 | Ni | HFAcAc | NO | 83% | 17% | 0.20 | 13.3 kPa | 800nm | 1900nm | 1700nm | 1500nm | 1400nm |
| Ex. 15 | Cr | HFAcAc | NO | 50% | 10% | 0.20 | 13.3 kPa | 600nm | 1500nm | 1300nm | 1000nm | 900nm |
| Ex. 16 | Mn | HFAcAc | NO | 50% | 10% | 0.20 | 13.3 kPa | 700nm | 1700nm | 1600nm | 1400nm | 1300nm |
| Ex. 17 | Fe | HFAcAc | NO | 50% | 10% | 0.20 | 13.3 kPa | 900nm | 2200nm | 2000nm | 2000nm | 1900nm |
| Ex. 18 | Co | HFAcAc | NO | 50% | 10% | 0.20 | 13.3 kPa | 800nm | 2000nm | 1800nm | 1600nm | 1500nm |
| Ex. 19 | Pt | HFAcAc | NO | 50% | 10% | 0.20 | 13.3 kPa | 400nm | 900nm | 900nm | 800nm | 600nm |
| Ex. 20 | NiFe | HFAcAc | NO | 50% | 10% | 0.20 | 13.3 kPa | 800nm | 1600nm | 1600nm | 1500nm | 1500nm |
| Ex. 21 | Ni | HFAcAc | NO+N2O | 50% | 5%+5% | 0.20 | 13.3 kPa | 600nm | 1600nm | 1600nm | 1500nm | 1200nm |

| | | | | | | | | | | | | |
|---|---|---|---|---|---|---|---|---|---|---|---|---|
| ∗HFAcAc: hexafluoroacetylacetone, TFAcAc: trifluoroacetylacetone | | | | | | | | | | | | |

### [Further Comparative Examples 1-6]

In the present test, the total flow rate of the cleaning gas to be introduced was 500 sccm. The diluting gas was N₂. The samples 7A, 7B, 7C, 7D, and 7E were respectively heated at 240 °C, 275 °C, 300 °C, 325 °C and 370 °C.

Furthermore, Examples 1, 2 and 3 were repeated except in that O₂ was used as the additive gas, in place of NOx (Comparative Examples 1, 2 and 3).

Furthermore, Example 14 was repeated except in that O₂ was used as the additive gas, in place of NOx (Comparative Example 4).

Furthermore, Example 1 was repeated except in that NO₂ was used as the additive gas, in place of NOx (Comparative Example 5).

Furthermore, Example 1 was repeated except in that NOx was not introduced into the cleaning gas (Comparative Example 6).

Table 2 shows the gas, the pressure and the temperature condition of the test and the result of calculating the amount of etching. As a result, it was confirmed that, in case that O₂ was used as the additive gas in place of NOx, the nickel foil sample was almost not etched at every sample temperature or etched at particular sample temperatures, not all sample temperatures.

**[Table 2]**

| Test No. | | | Additive gas | Conc. (vol. %) | | NOx/β-diketone vol. ratio | Chamber pressure kPa | Amount of etching (nm) | | | | |
|---|---|---|---|---|---|---|---|---|---|---|---|---|
| | Metal | β-diketone | | β-diketone | Additive gas | | | Sample A 240°C | Sample B 275°C | Sample C 300°C | Sample D 325°C | Sample E 370°C |
| Com. Ex. 1 | Ni | HFAcAc | O2 | 50% | 10% | 0.20 | 13.3kPa | <20nm | <20nm | <20nm | <20nm | 60nm |
| Com. Ex. 2 | Ni | HFAcAc | O2 | 50% | 5% | 0.10 | 13.3 kPa | <20nm | <20nm | <20nm | 400nm | 700nm |
| Com. Ex. 3 | Ni | HFAcAc | O2 | 50% | 2% | 0.04 | 13.3 kPa | <20nm | <20nm | 1500nm | 5000nm | 4500nm |
| Com. Ex. 4 | Ni | HFAcAc | O2 | 83% | 17% | 0.20 | 13.3 kPa | <20nm | <20nm | <20nm | <20nm | <20nm |
| Com. Ex. 5 | Ni | HFAcAc | NO2 | 50% | 10% | 0.20 | 13.3 kPa | <20nm | <20nm | <20nm | <20nm | <20nm |
| Com. Ex. 6 | Ni | HFAcAc | - | 50% | - | - | 13.3 kPa | <20nm | <20nm | <20nm | <20nm | <20nm |

| | | | | | | | | | | | | |
|---|---|---|---|---|---|---|---|---|---|---|---|---|
| ∗HFAcAc: hexafluoroacetylacetone | | | | | | | | | | | | |

### INDUSTRIAL APPLICABILITY

The present invention becomes effective for the removal of a metal film adhered in the inside of a film-formation chamber, particularly for the cleaning in case that the temperature difference among adhesion sites of the metal film is large.

### EXPLANATION OF SYMBOLS

- 1:: a chamber

- 21:: a β-diketone supply system
- 22:: a NOx supply system
- 23:: a diluting gas supply system
- 31, 32, 33 and 34:: valves
- 41 and 42:: gas pipes
- 5A, 5B, 5C, 5D and 5E:: heater stages
- 61, 62A, 62B, 62C, 62D and 62E:: heaters
- 7A, 7B, 7C, 7D and 7E:: samples
- 8:: a vacuum pump

## Claims

1. A dry-cleaning method for removing a metal film adhered to a film-formation apparatus by using β-diketone, the dry-cleaning method being **characterized by** that a gas containing β-diketone and NOx (representing at least one of NO and N₂O) is used as a cleaning gas and that the metal film within a temperature range of 200 °C to 400 °C is reacted with the cleaning gas, thereby removing the metal film,
wherein the gas has a NOx/β-diketone ratio by volume of from 0.02 to 0.60.

2. The dry-cleaning method as claimed in claim 1, which is **characterized by** that the β-diketone is hexafluoroacetylacetone or trifluoroacetylacetone.

3. The dry-cleaning method as claimed in claim 1 or claim 2, which is **characterized by** that the cleaning gas contains at least one gas selected from the group consisting of He, Ar, and N₂.

4. The dry-cleaning method as claimed in claim 1, which is **characterized by** that the metal film is constituted of at least one element of from group 6 to group 11 of the periodic table.

5. The dry-cleaning method as claimed in claim 4, wherein the metal film comprises any of Cr, Mn, Fe, Ni, Co, and Pt.

6. The dry-cleaning method as claimed in claim 4, wherein the metal film comprises NiFe, CoFe, CoFeNi, NiFeCr, NiFeMo, or CuNiFe.

7. The dry-cleaning method as claimed in claim 1, wherein the temperature range is from 250 °C to 370 °C.

8. The dry-cleaning method as claimed in claim 1, wherein the temperature range is from 260 °C to 350 °C.

## Patentansprüche

1. Trockenreinigungsverfahren zum Entfernen eines an einer Filmbildungsvorrichtung haftenden Metallfilms unter Verwendung von ß-Diketon, wobei das Trockenreinigungsverfahren **dadurch gekennzeichnet ist, dass** ein Gas, das ß-Diketon und NOx (das für NO und/oder N₂O steht) enthält, als Reinigungsgas verwendet wird, und dass der Metallfilm in einem Temperaturbereich von 200 °C bis 400 °C mit dem Reinigungsgas reagieren gelassen wird, wodurch der Metallfilm entfernt wird,
wobei das Gas ein NOx/ß-Diketon-Volumenverhältnis von 0,02 bis 0,60 aufweist.

2. Trockenreinigungsverfahren nach Anspruch 1, das **dadurch gekennzeichnet ist, dass** das ß-Diketon Hexafluoracetylaceton oder Trifluoracetylaceton ist.

3. Trockenreinigungsverfahren nach Anspruch 1 oder Anspruch 2, das
**dadurch gekennzeichnet ist, dass** das Reinigungsgas zumindest ein Gas enthält, das aus der Gruppe ausgewählt ist, die aus He, Ar und N₂ besteht.

4. Trockenreinigungsverfahren nach Anspruch 1, das **dadurch gekennzeichnet ist, dass** der Metallfilm aus zumindest einem Element aus der Gruppe 6 bis der Gruppe 11 des Periodensystems der Elemente gebildet ist.

5. Trockenreinigungsverfahren nach Anspruch 4, wobei der Metallfilm irgendeines von Cr, Mn, Fe, Ni, Co und Pt umfasst.

6. Trockenreinigungsverfahren nach Anspruch 4, wobei der Metallfilm NiFe, CoFe, CoFeNi, NiFeCr, NiFeMo oder CuNiFe umfasst.

7. Trockenreinigungsverfahren nach Anspruch 1, wobei der Temperaturbereich von 250 °C bis 370 °C beträgt.

8. Trockenreinigungsverfahren nach Anspruch 1, wobei der Temperaturbereich von 260 °C bis 350 °C beträgt.

## Revendications

1. Procédé de nettoyage à sec pour l'élimination d'un film métallique ayant adhéré sur un appareil de formation d'un film en utilisant une ß-dicétone, ledit procédé de nettoyage à sec étant **caractérisé en ce qu'**un gaz contenant de la ß-dicétone et des NOx (représentant au moins l'un parmi NO et N₂O) est utilisé comme gaz nettoyant et **en ce que** le film métallique dans une plage de températures allant de 200°C à 400°C réagit avec le gaz nettoyant, ce qui permet de retirer le film métallique,
dans lequel le gaz possède un rapport en volume NOx/ß-dicétone allant de 0,02 à 0,60.

2. Procédé de nettoyage à sec selon la revendication 1, qui est **caractérisé en ce que** la ß-dicétone est l'hexafluoroacétylacétone ou la trifluoroacétylacétone.

3. Procédé de nettoyage à sec selon la revendication 1 ou la revendication 2, qui est **caractérisé en ce que** le gaz nettoyant contient au moins un gaz choisi dans le groupe consistant en He, Ar et N₂.

4. Procédé de nettoyage à sec selon la revendication 1, qui est **caractérisé en ce que** le film métallique est constitué d'au moins un élément du groupe 6 au groupe 11 du tableau périodique des éléments.

5. Procédé de nettoyage à sec selon la revendication 4, dans lequel le film métallique comprend l'un quelconque parmi Cr, Mn, Fe, Ni, Co et Pt.

6. Procédé de nettoyage à sec selon la revendication 4, dans lequel le film métallique comprend du NiFe, CoFe, CoFeNi, NiFeCr, NiFeMo ou CuNiFe.

7. Procédé de nettoyage à sec selon la revendication 1, dans lequel la plage de températures va de 250°C à 370°C.

8. Procédé de nettoyage à sec selon la revendication 1, dans lequel la plage de température va de 260°C à 350°C.
